# EUROPÄISCHE PATENTSCHRIFT

(11) **EP 0 731 356 B1**
(45) Veröffentlichungstag und Bekanntmachung des Hinweises auf die Patenterteilung: **27.12.2000**
(21) Anmeldenummer: 96103141.6
(22) Anmeldetag: 01.03.1996
(51) Int. Cl.: G01P 3/481, G01R 19/175, H03K 5/153

(54) **Schaltungsanordnung zur Auswertung der Sensorsignale induktiver Sensoren von Kraftfahrzeugen**
Circuit for evaluating the signals of inductive sensors in vehicles
Circuit pour l'évaluation des signaux d'un capteur inductif dans un véhicule

(30) Priorität: 07.03.1995 DE 19507897
(43) Veröffentlichungstag der Anmeldung: 11.09.1996
(73) Patentinhaber: TEMIC TELEFUNKEN microelectronic GmbH, 90411 Nürnberg (DE)
(72) Erfinder: Alberter, Günther, 90409 Nürnberg (DE); Baumann, Jörg, 90587 Veitsbronn (DE); Breu, Gunther, 90473 Nürnberg (DE); Gutbrod, Wolfgang, 91096 Möhrendorf (DE)
(74) Vertreter: Maute, Hans-Jürgen, Dipl.-Ing.

(56) Entgegenhaltungen:
- EP-A- 0 288 119
- EP-A- 0 366 619
- US-A- 4 481 924
- US-A- 5 291 121
- PATENT ABSTRACTS OF JAPAN vol. 011, no. 367 (E-561), 28.November 1987 & JP-A-62 140511 (MATSUSHITA ELECTRIC IND CO LTD), 24.Juni 1987,

## Beschreibung

Die Erfindung betrifft eine Schaltungsanordnung zur Erkennung des Nulldurchgangs von Wechselspannungs-Sensorsignalen induktiver Sensoren von Kraftfahrzeugen wie sie aus der EP 0 366 619 A1 bekannt ist.
In Kraftfahrzeugen werden induktive Sensoren für unterschiedliche Aufgaben eingesetzt - beispielsweise zur Erfassung der Drehzahl oder Position bei Bewegungsvorgängen von bestimmten Komponenten oder Aggregaten des Kraftfahrzeugs (Motor, Getriebe etc.). Induktive Sensoren besitzen in der Regel einen einfachen Aufbau aus einer auf einen Weicheisenkern mit Dauermagneten angeordneten Spule und erfassen die als Folge des Bewegungsvorgangs auftretende Änderung des magnetischen Flusses. Auf den auszumessenden Komponenten oder Aggregaten des Kraftfahrzeugs werden hierzu Markierungen als Signalgeber angebracht - beispielsweise können als Signalgeber Zähne, Nasen, Vertiefungen oder Bohrungen vorgesehen werden. Die (periodische) Änderung des magnetischen Flusses ruft im induktiven Sensor eine Induktionsspannung als Meßwertsignal hervor, deren (periodischer) zeitlicher Verlauf ausgewertet wird; die Meßwertsignale der Sensoren (Sensorsignale) werden über Anschlußleitungen den Steuereinheiten des Kraftfahrzeugs für Steuerungs- oder Regelungsvorgänge zugeführt - beispielsweise für Motorsteuervorgänge, Getriebesteuervorgänge, ABS-Anwendungen oder Einspritzvorgänge.
Problematisch bei derartigen induktiven Sensoren von Kraftfahrzeugen ist, daß eine Abhängigkeit des Sensorsignals von der Bewegung des Signalgebers (Drehzahl, Winkelgeschwindigkeit, Exzentrik), vom Abstand des Sensors zum Signalgeber und von der Oberflächenbeschaffenheit des Signalgebers besteht, die starke Schwankungen in der Amplitude des Sensorsignals (Nutzsignals) hervorrufen kann, und daß zum andern (bedingt durch große Drehzahlunterschiede) ein großer Spannungsbereich des Sensorsignals erfaßt werden muß (beispielsweise 1 - 35 V). Hierdurch bedingt können oftmals Störsignale (Störspannungen) auftreten oder dem Sensorsignal überlagert sein, die in der Größenordnung von Nutzsignalen mit geringer Amplitude liegen; demzufolge ist die Zuverlässigkeit der von induktiven Sensoren gelieferten Sensorsignale nicht immer gewährleistet bzw. eine Weiterverarbeitung der Sensorsignale durch die entsprechenden Steuereinheiten des Kraftfahrzeugs nicht immer möglich - insbesondere kann der für viele Anwendungen (v. a. zur Positionserkennung) interessierende Nulldurchgang des Sensorsignals vielfach nicht exakt detektiert werden.

Bei der eingangs erwähnten gattungsgemäßen Schaltungsanordnung der EP 0 366 619 A1 wird mittels der Anpaßschaltung der Vergleichswert für den Spannungsvergleich der Komparatorschaltung zunächst vollständig gelöscht und anschließend wieder auf den aktuellen Wert des Wechselspannungs-Sensorsignals festgesetzt. Dies kann - insbesondere bei hohen Störsignalen und/oder geringen Nutzsignalen (d.h. bei ungünstigen Verhältnissen des Nutzsignals zum Störsignal) und/oder bei stark schwankenden Amplituden des Wechselspannungs-Sensorsignals (d.h. bei großen Amplitudendifferenzen des Nutzsignals) - zu falschen Interpretationen des Schaltschwelle und damit zu Fehlauslösungen führen.

Der Erfindung liegt die Aufgabe zugrunde, eine Schaltungsanordnung zur Erkennung des Nulldurchgangs von Wechselspannungs-Sensorsignalen induktiver Sensoren von Kraftfahrzeugen anzugeben, durch die das Sensorsignal zuverlässig verarbeitet werden kann und Störsignale sicher erkannt werden.
Diese Aufgabe wird gemäß der Erfindung durch die Merkmale im Patentanspruch 1 gelöst.
Vorteilhafte Weiterbildungen der Erfindung sind Gegenstand der weiteren Patentansprüche.

Dem Schaltungseingang der Schaltungsanordnung wird das (Wechselspannungs-) Sensorsignal über Sensorleitungen als Eingangssignal zugeführt; die Schaltungsanordnung erzeugt hieraus in Abhängigkeit der Amplitude des Sensorsignals ein charakteristisches Ausgangssignal beim Nulldurchgang des Sensorsignals (Wechsel von der positiven zur negativen Halbwelle) und stellt dieses Ausgangssignal den nachfolgenden Steuereinheiten des Kraftfahrzeugs zur Verfügung. Für jeden induktiven Sensor des Kraftfahrzeugs kann eine derartige Schaltungsanordnung zur Auswertung des Sensorsignals vorgesehen werden.
Die Schaltungsanordnung besitzt als Funktionseinheiten eine Eingangsstufe mit einer Eingangsschaltung und einer Referenzschaltung zur Verarbeitung des Eingangssignals und zur Erzeugung eines internen Bezugspotentials ("virtueller Nullpunkt") als Grundlage für die übrigen Schaltungskomponenten sowie eine Schwellwertstufe zur Detektion des Nulldurchgangs des Sensorsignals durch Erzeugung und Nachführung eines Spitzenschwellwerts ("Pegelnachführung") in Abhängigkeit der Amplitude des Sensorsignals; die Schwellwertstufe besteht aus einer Spitzenwertgleichrichterschaltung zur Bereitstellung eines Spitzenwerts als Auslösekriterium für die Erkennung des Nulldurchgangs, einer Anpaßschaltung zur Anpassung des Spitzenwerts an den geänderten Signalverlauf des Sensorsignals und somit zur Bereitstellung eines Vergleichswerts für die nächste Periode des Sensorsignals, einer Wandlerschaltung zur Umwandlung des Spitzenwerts und einer Komparatorschaltung zur Detektion des Nulldurchgangs. Weiterhin können als Funktionseinheiten der Schaltungsanordnung noch eine Dämpfungsstufe zur aktiven Bedämpfung des Sensorsignals bei hohen Signalamplituden des Sensorsignals - insbesondere von dem Sensorsignal überlagerten Störsignalen - und eine Fehlerstufe zur Fehlererkennung und Schaltungsdiagnose vorgesehen werden.

Vorteilhafterweise wird durch die beschriebene Schaltungsanordnung auf einfache Weise
- infolge der Pegelnachführung des Sensorsignals abhängig vom jeweils vorangegangenen Nutzsignalpegel und infolge der aktiven Störsignalbedämpfung bei hohem Nutzsignalpegel ein gutes Störsignal/ Nutzsignal-Verhältnis erzielt; damit wird die Störanfälligkeit des Sensorsignals reduziert und somit die Zuverlässigkeit der induktiven Sensoren erhöht,
- eine Diagnosefähigkeit ermöglicht, mit deren Hilfe Defekte der Sensorleitungen (Unterbrechungen oder Kurzschlüsse) und Defekte des induktiven Sensors (verpolte Sensorleitungen, ungenügende Signalerzeugung des Sensors infolge fehlerhafter Anordnung des Sensors) erkannt werden können.

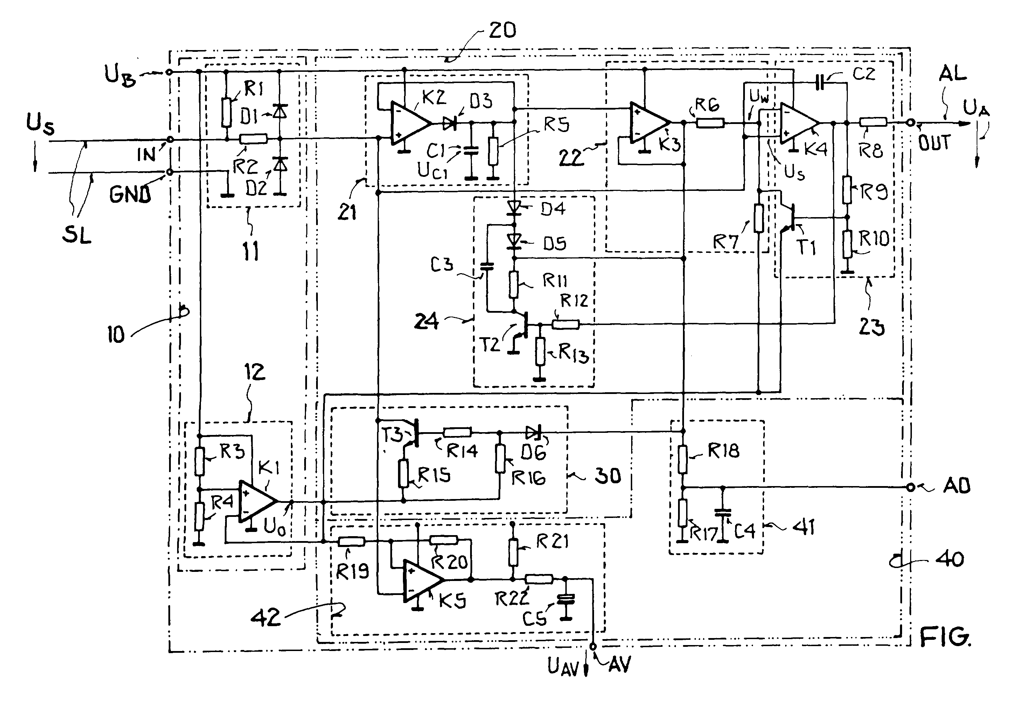

Weiterhin soll die Schaltungsanordnung zur Auswertung des Sensorsignals eines induktiven Sensors anhand eines Ausführungsbeispiels - der Kurbelwellensensorik/Nockenwellensensorik bei der Dieseleinspritzung eines Kraftfahrzeugs - näher beschrieben werden. Die Figur zeigt dabei eine Schaltungsanordnung mit den Funktionseinheiten und den zugehörigen Schaltungskomponenten.
Für den Einspritzvorgang muß die Position der Kurbelwelle und der Nockenwelle (beispielsweise mit einer Genauigkeit von 1°) bekannt sein; hierzu wird durch einen im Motorblock angebrachten induktiven Sensor die Bewegung eines auf der Kurbelwelle angebrachten, 36 Bohrungen aufweisenden Geberrads (Signalgeber) detektiert und hieraus ein Sinus-Wechselspannungssignal als Sensorsignal generiert sowie durch einen im Motorblock angebrachten induktiven Sensor die Bewegung eines auf der Nockenwelle angebrachten, eine Bohrung aufweisenden Geberrads detektiert und hieraus ein Sinus-Wechselspannungssignal als Sensorsignal generiert - der Nulldurchgang der beiden Sensorsignale dient als zeitliche Referenz für den Einspritzzeitpunkt. Zur Auswertung jedes der beiden Sensorsignale ist eine Schaltungsanordnung vorgesehen, die im Steuergerät für die Dieseleinspritzung integriert ist. Gemäß der Figur besteht die Schaltungsanordnung zur Detektion des Nulldurchgangs zwischen positiver und negativer Halbwelle des Wechselspannungs-Sensorsignals (der induktive Sensor muß eine derartige Polarität aufweisen, daß die positive Halbwelle zuerst anliegt) - aus einer Eingangsstufe 10, einer Schwellwertstufe 20, einer Dämpfungsstufe 30 und einer Fehlerstufe 40:

### Eingangsstufe 10:

- der Eingangsschaltung 11 (Widerstand R1, R2; Klemmdioden D1, D2) wird das Wechselspannungs-Sensorsignal U_{S} vom induktiven Sensor über die beiden Sensorleitungen SL am Schaltungseingang IN und am Anschluß für das (externe) Bezugspotential GND zugeführt; weiterhin liegt die Betriebsspannung U_{B} der Schaltungsanordnung von beispielsweise 12 V an. Der Widerstand R1 bildet mit dem Innenwiderstand des am Schaltungseingang IN/GND angeschlossenen induktiven Sensors einen Spannungsteiler; dieser Spannungsteiler ist beispielsweise so dimensioniert (R1 = 6,8 kΩ), daß die am Sensor anliegende Gleichspannung 1,9 V beträgt (Gleichspannungspegel des Sensorsignals). Der Widerstand R2 dient zur Strombegrenzung; die Dioden D1 und D2 sind Klemmdioden zur Spannungsbegrenzung.
- die Referenzschaltung 12 (Spannungsteiler aus Widerständen R3, R4; Impedanzwandler Komparator K1) bildet die Eingangsschaltung 11 bzw. deren Spannungsverhältnisse nach; durch die Referenzschaltung 12 wird somit abhängig von den Spannungsverhältnissen der Eingangsschaltung 11 eine Referenzspannung U₀ als Bezugsgröße für den Nulldurchgang des Sensorsignals U_{S} ("virtueller Nullpunkt") generiert, die den übrigen Funktionseinheiten bzw. Schaltungskomponenten als (internes) Bezugspotential zur Verfügung gestellt wird (gemäß obigem Beispielsfall beträgt U₀ = 1,9 V).

### Schwellwertsufe 20:

- durch die Spitzenwertgleichrichterschaltung 21 (Spitzenwert-Komparator K2; Diode D3; Tiefpaß Kondensator C1, Widerstand R5) wird während der positiven Halbwelle des dem nicht-invertierenden Eingang (+) des Spitzenwert-Komparators K2 zugeführten Sensorsignals U_{S} der Spitzenwert (Maximalwert) U_{Smax} des Sensorsignals U_{S} detektiert und im Kondensator C1 als Spannungswert U_{C1} gespeichert; der Tiefpaß (C1, R5) wird so dimensioniert, daß dessen Zeitkonstante groß gegenüber der Periodendauer des Sensorsignals U_{S} ist, d. h. der Spitzenwert U_{Smax} bleibt bis zur nächsten positiven Halbwelle des Sensorsignals U_{S} gespeichert.
- durch die Wandlerschaltung 22 (Impedanzwandler Komparator K3; Spannungsteiler Widerstände R6, R7) wird der Spitzenwert U_{Smax} des sensorsignals U_{S} halbiert und das Ausgangssignal U_{W} = ½ · U_{Smax} als Vergleichsspannung gebildet.
- durch die Komparatorschaltung 23 (Nulldurchgangs-Komparator K4; Rückkopplungs-Kondensator C2; Ausgangs-Spannungsteiler Widerstände R8, R9, R10; Schalt-Transistor T1) wird der Nulldurchgang des Sensorsignals U_{S} detektiert; hierzu wird dem nicht-invertierenden Eingang (+) des Komparators K4 das Sensorsignal U_{S} und dem invertierenden Eingang (-) des Komparators K4 die Vergleichsspannung U_{W} Ausgangssignal der Wandlerschaltung 22 (U_{W} = ½ · U_{Smax}) bzw. die von der Referenzschaltung 12 erzeugte Referenzspannung U₀ über den dem Schalt-Transistor T1 parallelgeschalteten Widerstand R7 der Wandlerschaltung 22 zugeführt. Während des Spannungsanstiegs der positiven Halbwelle des Sensorsignals U_{S} (U_{S} > U_{W}) ist der Ausgang des Komparators K4 auf High-Pegel, der Transistor T1 somit durchgesteuert und der Widerstand R7 des Spannungsteilers R6, R7 überbrückt, so daß am invertierenden Eingang (-) des Komparators K4 die Referenzspannung U₀ anliegt. Beim "Nulldurchgang" des Sensorsignals U_{S} (Übergang von positiver zu negativer Halbwelle) unterschreitet das Sensorsignal U_{S} den virtuellen Nullpunkt U₀ (U_{S} < U₀) und der Ausgang des Komparators K4 geht in den Low-Pegel über - diese Schaltflanke High-Low am Ausgang des Komparators K4 wird als Ausgangssignal U_{A} am schaltungsausgang OUT mittels des Ausgangs-Widerstands R8 über die Ausgangsleitung AL an das Steuergerät weitergegeben; gleichzeitig wird beim "Nulldurchgang" des Sensorsignals U_{S} (Low-Pegel am Ausgang des Komparators K4) der Schalt-Transistor T1 gesperrt, so daß am invertierenden Eingang (-) des Komparators K4 wieder die Vergleichsspannung U_{W} = ½ · U_{Smax} (d. h. 50 % der positiven Amplitude des Nutzsignals in der vorherigen Periode des Sensorsignals U_{S}) anliegt. Der nächste Nulldurchgang des Sensorsignals U_{S} (Übergang von positiver zu negativer Halbwelle) wird somit vom Komparator K4 erst dann wieder detektiert, wenn diese Vergleichsspannung U_{W} während der positiven Halbwelle des Sensorsignals U_{S} erreicht oder überschritten wurde - hierdurch werden Störsignale ausgeblendet, die maximal halb so groß wie das Nutzsignal der vorherigen Periode des Sensorsignals U_{S} sind.
- durch die Anpaßschaltung 24 (Diodenstrecke aus Dioden D4, D5; Schalt-Transistor T2; Entlade-Widerstand R11; Spannungsteiler mit den Widerständen R12, R13) erfolgt eine Nachführung des in der Spitzenwertgleichrichterschaltung 21 gespeicherten Maximalwerts U_{Smax} des Sensorsignals U_{S} auf den Schwellwert des Komparators K4 unmittelbar nach dem Erkennen einer Ansprechschwelle; hierdurch wird gewährleistet, daß der Schwellwert des Komparators K4 bei stetig signifikant schwächer werdendem Nutzsignal nicht permanent unterschritten und somit kein Nulldurchgang mehr detektiert wird. Hierzu ist der Ausgang des Komparators K4 über den Spannungsteiler R12, R13 mit der Steuerelektrode (Basis) des Schalt-Transistors T2 verbunden, dessen Ausgangselektrode (Kollektor) über den Entlade-Widerstand R11 und die Diodenstrecke Diode D5 (bzw. über den diesen beiden parallelgeschalteten Kondensator C3) und Diode D4 mit dem Ausgang der Spitzenwertgleichrichterschaltung 21 (dem Tiefpaß aus Kondensator C1 und Widerstand R5) verbunden ist. Während der positiven Halbwelle des Sensorsignals U_{S} und beim Überschreiten des Schwellwerts des Komparators K4 (High-Pegel des Ausgangs des Komparators K4) ist der Schalt-Transistor T2 durchgesteuert - dieser schaltet somit den Kondensator C3 über die Diode D4 parallel zum Kondensator C1 der Spitzenwertgleichrichterschaltung 21; falls die beiden Kondensatoren C1, C3 gleiche Kapazitätswerte besitzen, verteilt sich die auf dem Kondensator C1 gespeicherte Ladung zu gleichen Teilen auf die beiden Kondensatoren C1 und C3 und die Spannung U_{C1} auf dem Kondensator C1 sinkt auf den halben Wert U_{C1} = ½ · U_{Smax} - diese Spannung entspricht also gerade dem momentanen Schwellwert des Komparators K4. Im weiteren Verlauf der positiven Halbwelle des Sensorsignals U_{S} werden beide Kondensatoren C1, C3 durch die Spitzenwertgleichrichterschaltung 21 auf den neuen Spitzenwert U_{Smax} des Sensorsignals U_{S} aufgeladen. Nach dem Nulldurchgang des Sensorsignals U_{S} (Low-Pegel am Ausgang des Komparators K4) wird der Schalt-Transistor T2 gesperrt und der Kondensator C3 über die Diode D5 und den Widerstand R11 entladen, so daß bei der nächsten Halbwelle die Anpaßschaltung 24 wieder einsatzbereit ist. Durch eine Verbindung der Diode D5 mit dem Ausgang des Komparators K3 der Wandlerschaltung 22 liegt an den beiden Anschlüssen der Diode D5 das gleiche Potential an; demzufolge wird verhindert, daß eine Entladung der Kondensatoren C1 und C3 unmittelbar nach dem Aufladen auf den Spitzenwert U_{Smax} des Sensorsignals U_{S} erfolgen kann.

### Dämpfungsstufe 30:

Bedingt durch die induktive Generierung des Sensorsignals U_{S} tritt oftmals (beispielsweise bei hohen Drehzahlen des Signalgebers und bei geringem Abstand des Signalgebers vom induktiven Sensor) das Problem der Übersteuerung auf, d. h. die Amplitude des Sensorsignals U_{S} überschreitet die maximal von der Schaltungsanordnung noch verarbeitbare Eingangsspannung. Weiterhin kann in manchen Fällen der Schwellwert des Komparators K4 der Komparatorschaltung 23 von Störsignalen erreicht und so fälschlicherweise ein nicht vorhandener Nulldurchgang des Sensorsignals U_{S} signalisiert werden (d. h. es wird ein Fehlimpuls am Schaltungsausgang OUT ausgelöst). Zur Vorbehandlung des Sensorsignals U_{S} (aktive Bedämpfung des Sensorsignals U_{S} in Abhängigkeit von dessen Größe) weist die Dämpfungsstufe 30 einen Dämpfungs-Transistor T3 mit Emitter-Widerstand R15, einen zwischen Basis und Emitter des Dämpfungs-Transistors T3 geschalteten Spannungsteiler Widerstände R14, R16 und eine den Abgriff des Spannungsteilers R14, R16 mit dem Ausgang des Komparators K3 der Wandlerschaltung 22 verbindende Zener-Diode D6 auf.
Überschreitet die Spannung U_{Smax} am Ausgang der Wandlerschaltung 22 einen von der Durchbruchspannung U_{Z} der Zener-Diode D6 festgelegten Wert (beispielsweise U_{Z} = 4,7 V), wird der Transistor T3 durchgesteuert und über die Verbindung zwischen dem Kollektor des Transistors T3 und dem Widerstand R2 der Eingangsschaltung 11 das Sensorsignal U_{S} bedämpft. Durch die gewählte Anordnung (Widerstände R14, R15, R16; Diode D6) wird eine geschlossene Regelschleife gebildet, die auf eine Obergrenze von U_{Smax} regelt und somit den Arbeitspunkt des Transistors T3 stabilisiert. Da der Arbeitspunkt des Transistors T3 durch entsprechende Wahl der Widerstandswerte der Widerstände R2, R14, R15 bei kleinen Signalpegeln im steilen Abschnitt dessen Ausgangs-Kennlinienfelds liegt (kleiner differentieller Widerstand), werden Störsignale stärker bedämpft als das Nutzsignal; hierdurch wird eine Verbesserung des Nutzsignal/Störsignal-Verhältnisses und demzufolge auch im übersteuerten Betriebsbereich der Schaltungsanordnung eine hohe Betriebssicherheit erreicht.

### Fehlerstufe 40:

- durch die Diagnoseschaltung 41 mit dem Spannungsteiler Widerstände R17, R18 und dem Kondensator C4 werden die Diagnosefunktionen Erkennung von Unterbrechungen und Kurzschlüssen der Sensorleitungen SL und Erkennung des fehlerhaften Einbaus des induktiven Sensors realisiert. Hierzu ist der Ausgang der Wandlerschaltung 22 mit dem Spannungsteiler R17, R18 verbunden; die am Ausgang der Wandlerschaltung 22 anliegende Gleichspannung U_{Smax} wird durch den Spannungsteiler R17, R18 auf den Bereich 0 V (Minimalspannung) bis 5 V (Maximalspannung) normiert. Das Ausgangssignal der Diagnoseschaltung 41 wird am Diagnoseausgang DA der Schaltungsanordnung ausgegeben und beispielsweise einem dort angeschlossenen D/A-Wandler zur Verarbeitung zugeführt.
   Im Falle einer Unterbrechung der Sensorleitung (Kabelbruch) steht die volle Betriebsspannung U_{B} (beispielsweise 12V) am Schaltungseingang IN an, so daß am Diagnoseausgang DA als Maximalspannung der Spannungspegel 5 V ausgegeben wird.
   Im Falle eines Kurzschlusses der Sensorleitungen SL steht als Betriebsspannung U_{B} die Spannung 0 V am Schaltungseingang IN an, so daß am Diagnoseausgang DA als Minimalspannung der Spannungspegel 0 V ausgegeben wird.
   Da die Amplitude des Nutzsignals unter anderem vom Abstand des Signalgebers zum induktiven Sensor abhängt, kann die Anordnung (Einbaulage) des induktiven Sensors durch Messung und Auswertung der Amplitude des Sensorsignals U_{S} kontrolliert werden; der auf den Bereich 0... 5 V normierte Spannungsverlauf wird am Diagnoseausgang DA ausgegeben und ist bei "falscher" Anordnung des induktiven Sensors (beispielsweise falls sich der induktive Sensor infolge von Vibrationen aus seiner Umhüllung löst) derart, daß ein drehzahlabhängiger Erwartungswert unterschritten wird.
   In allen anderen Fällen steht am Diagnoseausgang DA die "korrekte" Spannung U₀ des virtuellen Nullpunkts von beispielsweise U₀ = 1,9 V an.
- durch die Verpolschaltung 42 wird eine Verpolung des induktiven Sensors (d. h. eine Vertauschung der Sensorleitungen SL) erkannt und somit sichergestellt, daß die positive Halbwelle des Sensorsignals U_{S} vor der negativen Halbwelle anliegt (dies muß zur sicheren Auswertung des Sensorsignals erfüllt sein); hierzu ist die Verpolschaltung 42 als Schmitt-Trigger-Schaltung mit dem Komparator K5, dem Eingangs-Widerstand R19, den Rückkopplungs-Widerständen R20, R21, und dem Tiefpaß Widerstand R22, Kondensator C5 ausgebildet. Durch die Widerstände R19, R20 wird eine Schalt-Hysterese erzeugt; infolge der Verbindung des nicht-invertierenden Eingangs (+) des Komparators K5 über den Widerstand R19 zur Referenzspannung U₀ (virtueller Nullpunkt) und des invertierenden Eingangs (-) des Komparators K5 zum Ausgang der Eingangsschaltung 11 liegt beim Durchlaufen der positiven Halbwelle des Sensorsignals U_{S} der Ausgang des Komparators K5 auf Low-Pegel, und nimmt - bedingt durch die Hysterese - erst während der negativen Halbwelle des Sensorsignals U_{S} einen High-Pegel an. Je nach Anordnung des Signalgebers (Markierungen) und der Polarität des induktiven Sensors ergibt sich ein unterschiedliches Tastverhältnis am Ausgang des Komparators K5, das über den Tiefpaß Widerstand R22, Kondensator C5 integriert wird und als Gleichspannungssignal U_{AV} am verpolausgang AV der Schaltungsanordnung ausgegeben wird. Durch Auswertung dieses Ausgangssignals am Verpolausgang AV kann somit die Polung der Sensoranschlüsse bzw. Sensorleitungen SL erkannt werden; beispielsweise ist bei einem Tastverhältnis von weniger als 1:2 (und daher einem Gleichspannungssignal U_{AV} < ½ · U_{B}) eine Verpolung der Sensorleitungen gegeben, während bei einem Tastverhältnis von mehr als 1:2 (Gleichspannungssignal U_{AV} > ½ · U_{B}) keine Verpolung der Sensorleitungen vorliegt.

## Patentansprüche

1. Schaltungsanordnung zur Erkennung des Nulldurchgangs von Wechselspannungs-Sensorsignalen (U_{S}) induktiver Sensoren von Kraftfahrzeugen, aus
a) einer Eingangsstufe (10) mit einer Eingangsschaltung (11), der das Wechselspannungs-Sensorsignal (U_{S}) als Eingangssignal zur Verarbeitung zugeführt wird,
b) einer Schwellwertstufe (20) mit
b1) einer mit dem Ausgang der Eingangsstufe (10) verbundenen Spitzenwertgleichrichterschaltung (21) zur Bereitstellung des Spitzenwerts (U_{Smax}) des Wechselspannungs-Sensorsignals (U_{S}) als Auslösekriterium für die Erkennung des Nulldurchgangs des Wechselspannungs-Sensorsignals (U_{S}),
b2) einer der Spitzenwertgleichrichterschaltung (21) nachgeschalteten Wandlerschaltung (22) zur Umwandlung des Spitzenwerts (U_{Smax}) des Wechselspannungs-Sensorsignals (U_{S}) durch Reduzierung um einen bestimmten Teilerfaktor und zur Bereitstellung einer Ausgangsspannung (U_{W}) als Vergleichsspannung,
b3) einer der Wandlerschaltung (22) nachgeschalteten Komparatorschaltung (23) zur Detektion des Nulldurchgangs des Wechselspannungs-Sensorsignals (U_{S}) durch einen Spannungsvergleich und zur Ausgabe des Ausgangssignals, wobei die Schaltungsanordnung derart ausgebildet ist, daß an einem ersten Eingang der Komparatorschaltung (23) das Wechselspannungs-Sensorsignal (U_{S}) angelegt wird und an einem zweiten Eingang der Komparatorschaltung (23) während des Spannungsanstiegs der positiven Halbwelle des Wechselspannungs-Sensorsignals (U_{S}) beim Überschreiten der Vergleichsspannung (U_{W}) eine Referenzspannung (U₀) zum Erkennen des Nulldurchgangs, beim Erkennen des Nulldurchgangs des Wechselspannungs-Sensorsignals (U_{S}) durch Unterschreiten der Referenzspannung (U₀) die Vergleichsspannung (U_{W}) und während des nächsten Spannungsanstiegs der positiven Halbwelle des Wechselspannungs-Sensorsignals (U_{S}) beim überschreiten der Vergleichsspannung (U_{W}) wieder die Referenzspannung (U₀) angelegt wird,
b4) und einer Anpaßschaltung (24) zur Anpassung des Spitzenwerts (U_{Smax}) des Wechselspannungs-Sensorsignals (U_{S}) an den geänderten Signalverlauf des Wechselspannungs-Sensorsignals (U_{S}),
wobei
c) zur Bereitstellung der Vergleichsspannung (U_{W}) für den während der nächsten Periode des Wechselspannungs-Sensorsignals (U_{S}) durch die Komparatorschaltung (23) erfolgenden Spannungsvergleich
c1) die Anpaßschaltung (24) einen Schalt-Transistor (T2) aufweist, dessen Steuerelektrode über einen Spannungsteiler (R12, R13) mit dem Ausgang der Komparatorschaltung (23) verbunden ist, und dessen Ausgangselektrode über einen Entlade-Widerstand (R11) und eine Diodenstrecke aus zwei Dioden (D4, D5) mit einem am Ausgang der Spitzenwertgleichrichterschaltung 21 angeordneten Tiefpaß (C1, R5) verbunden ist,
c2) die Anpaßschaltung (24) einen Kondensator (C3) aufweist, der dem Entlade-Widerstand (R11) und der zweiten Diode (D5) der Diodenstrecke parallelgeschaltet ist,
c3) die Anpaßschaltung (24) über die zweite Diode (D5) der Diodenstrecke mit dem Ausgang der Wandlerschaltung (22) verbunden ist.

2. Schaltungsanordnung nach Anspruch 1, dadurch gekennzeichnet, daß die Eingangsstufe (10) eine Referenzschaltung (12) zur Erzeugung eines internen Bezugspotentials aufweist, die abhängig von den Spannungsverhältnissen der Eingangsschaltung (11) die Referenzspannung (U₀) als Bezugsgröße für den Nulldurchgang des Wechselspannungs-Sensorsignals (U_{S}) generiert.

3. Schaltungsanordnung nach Anspruch 1 oder 2, dadurch gekennzeichnet, daß zur aktiven Bedämpfung des Wechselspannungs-Sensorsignals (U_{S}) bei hohen Amplituden eine mit dem Ausgang der Referenzschaltung (12), dem Eingang der Spitzenwertgleichrichterschaltung (21) und dem Ausgang der Wandlerschaltung (22) verbundene Dämpfungsstufe (30) vorgesehen ist.

4. Schaltungsanordnung nach einem der Ansprüche 1 bis 3, dadurch gekennzeichnet, daß zur Erkennung von Defekten der Sensorleitungen (SL) und Defekten des induktiven Sensors eine Fehlerstufe (40) aus einer mit dem Ausgang der Wandlerschaltung (22) verbundenen Diagnoseschaltung (41) und einer mit dem Ausgang der Referenzschaltung (12) verbundenen Verpolschaltung (42) vorgesehen ist.

## Claims

1. A circuit arrangement for detecting the zero-crossing of alternating voltage sensor signals (U_{S}) from inductive sensors in motor vehicles consisting of
a) an input stage (10) having an input circuit (11) to which the alternating voltage sensor signal (U_{S}) is fed as an input signal for further processing,
b) a threshold stage (20) incorporating
b1) a peak rectifier circuit (21) connected to the output of the input stage (10) for producing the peak value (U_{Smax}) of the alternating voltage sensor signal (U_{S}) in the form of a triggering criterion for the detection of the zero-crossing of the alternating voltage sensor signal (U_{S}),
b2) a converter circuit (22) connected to the output of the peak rectifier circuit (21) for converting the peak value (U_{Smax}) of the alternating voltage sensor signal (U_{S}) by a process of reducing it by a certain division factor and producing an output signal (U_{W}) in the form of a comparison voltage,
b3) a comparator circuit (23) connected to the output of the converter circuit (22) for detecting the zero-crossing of the alternating voltage sensor signal (U_{S}) by means of a voltage comparison process and for supplying the output signal, whereby the circuit arrangement is arranged such that the alternating voltage sensor signal (U_{S}) is applied to a first input of the comparator circuit (23) and a reference voltage (U₀) for detecting the zero-crossing is applied to a second input of the comparator stage (23) during the rising voltage portion of the positive half-wave of the alternating voltage sensor signal (U_{S}) when the comparison voltage (U_{W}) is exceeded, the comparison voltage (U_{W}) is applied to said second input of the comparator stage when the alternating voltage sensor signal (U_{S}) falls below the reference voltage (U₀) upon the detection of the zero-crossing of the alternating voltage sensor signal (U_{S}), and the reference voltage (U₀) is applied again to said second input of the comparator stage when the comparison voltage (U_{W}) is exceeded during the next rising voltage portion of the positive half-wave of the alternating voltage sensor signal (U_{S}),
b4) and a matching circuit (24) for matching the peak value (U_{Smax}) of the alternating voltage sensor signal (U_{S}) to the altered signal waveform of the alternating voltage sensor signal (U_{S}),
wherein
c) for the purposes of preparing the comparison voltage (U_{W}) for the voltage comparison process occurring during the next period of the alternating voltage sensor signal (U_{S}) by the comparator circuit (23)
c1) the matching circuit (24) comprises a switching transistor (T2) whose control electrode is connected via a voltage divider (R12, R13) to the output of the comparator circuit (23), and whose output electrode is connected via a discharge resistance (R11) and a diode path consisting of two diodes (D4, D5) to a low pass filter (C1, R5) arranged at the output of the peak rectifier circuit 21,
c2) the matching circuit (24) comprises a capacitor (C3) which is connected in parallel with the discharge resistance (R11) and the second diode (D5) of the diode path,
c3) the matching circuit (24) is connected via the second diode (D5) of the diode path to the output of the converter circuit (22).

2. A circuit arrangement in accordance with Claim 1, characterised in that the input stage (10) comprises a reference circuit (12) for producing an internal reference potential which generates the reference voltage (U₀) acting as a reference magnitude for the zero-crossing of the alternating voltage sensor signals (U_{S}) in dependence on the voltage ratios in the input circuit (11).

3. A circuit arrangement in accordance with Claim 1 or 2,
characterised in that an attenuating stage (30), which is connected to the output of the reference circuit (12), to the input of the peak rectifier circuit (21) and to the output of the converter circuit (22), is provided for actively attenuating the alternating voltage sensor signal (U_{S}) at high amplitudes thereof.

4. A circuit arrangement in accordance with any of Claims 1 to 3, characterised in that a fault detecting stage (40) consisting of a diagnostic circuit (41) connected to the output of the converter circuit (22) and a reversal detecting circuit (42) connected to the output of the reference circuit (12) is provided for detecting defects in the sensor lines (SL) and defects in the inductive sensors.

## Revendications

1. Montage pour identifier le passage par zéro de signaux de tension alternative (U_{S}) de capteurs inductifs de véhicules automobiles, constitué par :
a) un étage d'entrée (10) comportant un circuit d'entrée (11), auquel le signal à tension alternative (U_{S}) du capteur est envoyé en tant que signal d'entrée, pour son traitement,
b) un étage à valeur de seuil (20) comportant
b1) un circuit (22) de redressement de la valeur maximale, qui est relié à la sortie de l'étage d'entrée (10) et sert à préparer la valeur maximale (U_{Smax}) du signal de tension alternative (U_{S}) du capteur en tant que critère de déclenchement pour l'identification du passage par zéro du signal de tension alternative (U_{S}) du capteur,
b2) un circuit convertisseur (22) qui est branché en aval du circuit (21) de redressement de la valeur maximale et sert à convertir la valeur maximale (U_{Smax}) du signal de tension alternative (U_{S}) du capteur par réduction d'un facteur de division déterminé et pour préparer une tension de sortie (U_{W}) en tant que tension de comparaison,
b3) un circuit comparateur (23), qui est branché en aval du circuit convertisseur (22) et sert à détecter le passage par zéro du signal de tension alternative (U_{S}) du capteur au moyen d'une comparaison de tension et sert à délivrer le signal de sortie, le montage étant agencé de telle sorte que le signal de tension alternative (U_{S}) du capteur est appliqué à une première entrée du circuit comparateur (23) et qu'une tension de référence (U₀) servant à identifier le passage par zéro est appliquée à une seconde entrée du circuit comparateur (23) pendant la montée de la tension de l'alternance positive du signal de tension alternative (U_{S}) du capteur, lors du dépassement de la tension de comparaison (U_{W}), que la tension de comparaison (U_{W}) est appliquée à la seconde entrée du circuit comparateur lors de l'identification du passage par zéro du signal de tension alternative (U_{S}) du capteur lors du dépassement de la tension de référence (U₀) par valeurs inférieures, et qu'à nouveau la tension de référence (U₀) est appliquée à la seconde entrée du circuit comparateur, pendant la montée suivante de la tension de l'alternance positive du signal de tension alternative (U_{S}) du capteur, lors du dépassement de la tension de comparaison (U_{W}) par valeurs supérieures, et
b4) et un circuit d'adaptation (24) servant à adapter la valeur maximale (U_{Smax}) du signal de tension alternative (U_{S}) à l'allure modifiée du signal de tension alternative (U_{S}) du capteur,
dans lequel
c) pour la délivrance de la tension de comparaison (U_{W}) pour la comparaison de tension qui est exécutée pendant la période suivante du signal de tension alternative (U_{S}) du capteur par le circuit comparateur (23)
c1) le circuit d'adaptation (24) comporte un transistor de commutation (T2), dont l'électrode de commande est reliée par l'intermédiaire d'un diviseur de tension (R12,R13) à la sortie du circuit comparateur (23) et dont l'électrode de sortie est reliée par l'intermédiaire d'une résistance de décharge (R11) et d'une section à diodes constituée de deux diodes (D4,D5) à un filtre passe-bas (C1,R5) disposé à la sortie du circuit (21) de redressement de la valeur maximale,
c2) le circuit d'adaptation (24) comporte un condensateur (C3), qui est branché en parallèle avec la résistance de décharge (R11) et la seconde diode (D5) de la section à diodes,
c3) le circuit d'adaptation (24) est relié au moyen de la seconde diode (D5) de la section de diodes à la sortie du circuit convertisseur (22).

2. Montage selon la revendication 1, caractérisé en ce que l'étage d'entrée (10) comporte un circuit de référence (12) servant à produire un potentiel de référence interne, qui, en fonction des conditions de tension du circuit d'entrée (11), génère la tension de référence (U₀) en tant que grandeur de référence pour le passage par zéro du signal de tension alternative (U_{S}) du capteur.

3. Montage selon la revendication 1 ou 2, caractérisé en ce que pour l'amortissement actif du signal de tension alternative (U_{S}) du capteur, pour des amplitudes élevées, il est prévu un étage d'amortissement (30), qui est relié à la sortie du circuit de référence (12), à l'entrée du circuit (21) de redressement de la valeur maximale et à la sortie du circuit convertisseur (22).

4. Montage selon l'une des revendications 1 à 3, caractérisé en ce que pour l'identification de défauts des lignes (SL) des capteurs et de défauts du capteur inductif, il est prévu un étage (40) de traitement de défauts constitué par un circuit de diagnostic (41) relié à la sortie du circuit convertisseur (22), et à un circuit d'inversion de polarité (42) relié à la sortie du circuit de référence (12).
